Europäisches Patentamt

European Patent Office

Office européen des brevets

(19)

(11) **EP 0 553 050 B1**

(12) **FASCICULE DE BREVET EUROPEEN**

(45) Date de publication et mention
de la délivrance du brevet:
**16.10.1996 Bulletin 1996/42**

(51) Int Cl.$^6$: **H03M 13/12**

(21) Numéro de dépôt: **93460003.2**

(22) Date de dépôt: **22.01.1993**

(54) **Procédé de décodage à maximum de vraisemblance à treillis de décodage sous-échantillonné, et dispositif de décodage correspondant**

Verfahren zur Maximalwahrscheinlichkeitsdekodierung mit unterabgetastetem Dekodierungstrellis und entsprechende Dekodierungsvorrichtung

Maximum likelihood decoding process with subsampled decoding trellis, and decoding device therefor

(84) Etats contractants désignés:
**DE GB IT**

(30) Priorité: **24.01.1992 FR 9201047**

(43) Date de publication de la demande:
**28.07.1993 Bulletin 1993/30**

(73) Titulaires:
- **FRANCE TELECOM**
  **75015 Paris (FR)**
- **TELEDIFFUSION DE FRANCE**
  **75932 Paris Cédex 15 (FR)**

(72) Inventeurs:
- **Alard, Michel**
  **F-75014 Paris (FR)**
- **Castelain, Damien**
  **F-35000 Rennes (FR)**
- **Helard, Jean-François**
  **F-35700 Rennes (FR)**

(74) Mandataire: **Vidon, Patrice**
**Cabinet Patrice Vidon,**
**Immeuble Germanium,**
**80, Avenue des Buttes-de-Coesmes**
**35700 Rennes (FR)**

(56) Documents cités:
**EP-A- 0 297 375        EP-A- 0 463 598**

- **PROCEEDINGS OF THE GLOBAL TELECOMMUNICATIONS CONFERENCE, San Diego, December 2-5, 1990 (GLOBECOM '90) vol. 3, 1991, New York, IEEE, US, pp 1712-1716; G. FETTWEIS et al.: 'Minimized Method Viterbi Decoding: 600 Mbit/s per Chip'**
- **EUROCON 88: 8TH EUROPEAN CONFERENCE ON ELECTROTECHNICS, June 13-17 1988, Goteborg, Sweden, CONFERENCE PROCEEDINGS ON AREA COMMUNICATION 1988, New York, IEEE, US, pp 110-113; T. AULIN ET AL.: 'Two Classes of Algorithms for Asymptotically Optimal Simplified MLSD with Application to Digital Radio'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

Le domaine de l'invention est celui du décodage de données numériques codées à l'aide de codes convolutifs. Plus précisément, l'invention concerne les techniques de décodage mettant en oeuvre la règle de décision du maximum de vraisemblance, et notamment celles utilisant un algorithme décisionnel du type de l'algorithme de Viterbi.

Le codage convolutif est une technique actuellement très utilisée, notamment lorsque les données sont transmises en présence de bruit de transmission, et par exemple pour la diffusion de signaux numériques sonores (DAB : Digital Audio Broadcasting (diffusion audionumérique)), d'images (DNT : Diffusion Numérique de Terre et TVHD : Télévision Haute Définition) ou de données...

Le principe général du codage convolutif est d'associer à une donnée source au moins une valeur codée, obtenue par combinaison linéaire de cette donnée source avec au moins une des données source précédentes.

Classiquement, de tels codes sont décodés à l'aide d'un algorithme à maximum de vraisemblance, du type de l'algorithme de Viterbi. Cet algorithme fournit une estimation binaire de chaque symbole codé à l'émission, à partir du symbole reçu correspondant et d'un jeu des symboles reçus précédents. Cette estimation binaire peut éventuellement être pondérée.

L'algorithme de Viterbi, qui sera décrit plus en détail par la suite, repose sur la détermination d'un chemin optimal dans un treillis, par l'élimination systématique d'un chemin parmi au moins deux chemins possibles atteignant chaque noeud du treillis. Pour chaque noeud, on détermine donc au moins deux métriques de transition, représentatives de la distance entre la transition possible sur chaque chemin et la valeur effectivement reçue par le décodeur. Ces métriques de transition permettent de calculer des métriques cumulées, représentatives du bruit cumulé sur le chemin considéré. Une métrique cumulée est ainsi une intégrale des métriques de transition. Selon l'algorithme de Viterbi, seul le chemin correspondant à la métrique cumulée la plus faible (survivant) est conservé.

Le décodage proprement dit consiste à remonter dans le treillis ce chemin optimal et à fixer comme valeur des échantillons reçus les valeurs correspondant à l'extrémité de ce chemin optimal.

L'invention concerne essentiellement la gestion des chemins survivants et la remontée du chemin optimal.

En effet, la mise en oeuvre des algorithmes à maximum de vraisemblance pose de nombreux problèmes, notamment lorsqu'on désire les implanter dans des composants intégrés, en vue de leur exploitation industrielle, et en particulier pour des fonctionnement à des fréquences d'échantillonnage élevées.

Il se pose notamment le problème classique de l'optimisation des deux caractéristiques essentielles que sont la surface utile du circuit intégré et le temps de calcul.

Dans les composants intégrés actuellement disponibles sur le marché, deux méthodes connues sont mises en oeuvre, dites respectivement, en terminologie anglo-saxonne, méthode "Trace-Back" (remontée) et méthode "Register Exchange" (échange de registres).

La première méthode ("Trace-Back") est par exemple mise en oeuvre dans les différents circuits SOR 5053, SOR 5073, SOR 5003,... fabriqués et distribués par la société SOREP (marque déposée).

Elle met en oeuvre une mémoire vive classique (RAM : "Random Access Memory" en anglo-saxon) pour le stockage des métriques de chemin. L'écriture dans la mémoire des décisions (chemins survivants) et la remontée du chemin optimal doivent être effectuées simultanément.

Cette remontée consiste classiquement à relire une à une les décisions stockées dans la mémoire, dans le sens opposé à celui de la mémorisation, de façon à retracer le chemin optimal à travers le diagramme du treillis.

Il apparaît clairement que cette méthode ne peut pas être mise en oeuvre à des débits très élevés, du fait du nombre important d'opérations successives d'écriture et surtout de lecture à effectuer.

Ce problème est d'autant plus crucial que, bien sûr, la qualité du décodage est directement fonction du nombre d'échantillons reçus pris en compte, c'est-à-dire de la longueur de troncature du décodage.

La seconde méthode "Register Exchange" permet de fonctionner à des vitesses plus importantes, mais au prix d'une complexité, et donc d'une surface de silicium, beaucoup plus grande. Ainsi, la mise en oeuvre de cette méthode pour le système SPORT (marque déposée), produit et diffusé par NTT (marque déposée) nécessite deux circuits distincts.

Cette méthode utilise pour chaque état possible du codage un registre à décalage, contenant toute l'information sur le chemin conduisant à cet état. Ainsi, contrairement à la méthode précédente, il n'y a pas besoin d'effectuer une remontée du treillis. L'information de décodage est obtenue directement, ce qui permet bien sûr d'atteindre des débits supérieurs.

Ces différents registres sont interconnectés entre eux, conformément au treillis correspondant au code choisi.

Pour chaque nouvelle métrique calculée, les registres sont interchangés, en fonction du résultat du calcul et du treillis, et les plus anciens symboles de chacun des registres sont délivrés en sortie.

Chaque registre à décalage doit donc avoir une longueur égale à la mémoire des chemins, ou longueur de troncature (la longueur de troncature représente la profondeur du treillis à partir de laquelle on considère qu'une décision peut être prise avec une sécurité suffisante).

En d'autres termes, cette méthode nécessite de nombreux échanges de données entre registres, mais, en revanche, aucune remontée du treillis, chaque registre contenant toute l'information sur le chemin conduisant à l'état de codage correspondant. Il est donc possible d'utiliser cette méthode à des fréquences élevées.

Toutefois, cette technique est limitée, sur le plan technologique, par la surface de silicium nécessaire. En effet, alors qu'un point mémoire (correspondant à un noeud du treillis) nécessite 4 à 5 transistors dans une mémoire statique classique (méthode "trace-back"), il est constitué d'une bascule D, soit environ 15 transistors, dans le cas de la méthode par échange de registres.

La surface nécessaire pour le stockage des données est donc environ multipliée par trois. De plus, on estime généralement que les interconnexions reliant les registres doublent encore cette surface.

Une autre technique est encore décrite dans EP- 0 297 375. Elle repose sur une structure parallèle permettant de sous-échantillonner le treillis, mais présente les mêmes inconvénients que ci-dessus.

L'invention a notamment pour objectif de pallier ces différents inconvénients de l'état de la technique.

Plus précisément, un objectif de l'invention est de fournir un procédé de décodage à maximum de vraisemblance de données codées à l'aide d'un code convolutif, qui soit susceptible d'être mis en oeuvre à des débits élevés, et notamment à des débits supérieurs à ceux actuellement autorisés par les décodeurs selon la méthode de remontée du chemin optimal.

En d'autres termes, l'invention a pour objectif de fournir une telle méthode qui réduise le nombre d'accès à une mémoire, pour une longueur de troncature donnée, ou qui, inversement, permette d'augmenter cette longueur de troncature, et donc la qualité du décodage, pour un nombre d'écriture/lecture fixé.

Un autre objectif de l'invention est de fournir un tel procédé de décodage, qui nécessite une surface de silicium raisonnable, lorsqu'il est implanté dans un circuit intégré, et notamment une surface inférieure à celle exigée par la méthode à échange de registres.

En particulier, l'invention a pour objectif de fournir un tel procédé, qui puisse être implanté dans un circuit intégré unique, à un coût de revient et selon une technologie compatibles avec une diffusion grand public, par exemple pour les récepteurs de signaux sonores ou d'images numériques.

En d'autres termes, un objectif essentiel du procédé de l'invention est de fournir un tel procédé, optimisant le rapport surface utile de silicium/temps de traitement.

Un autre objectif de l'invention est encore de fournir un tel procédé de décodage, qui puisse être mis en oeuvre pour le décodage de tout type de codes convolutifs, et notamment des modulations codées en treillis (MCT).

Par ailleurs, l'invention a également pour objectif de fournir un tel procédé, qui ne nécessite aucune adaptation des décodeurs, par rapport aux procédés classiques. Notamment, un objectif de l'invention est de fournir un tel procédé, qui puisse être mis en oeuvre concurremment à d'autres procédés, par exemple dans certains types particuliers de récepteurs, destinés soit à la réception haut de gamme, soit à la réception dans des conditions difficiles.

En d'autres termes, l'invention a pour objectif de fournir un tel procédé n'introduisant pas de modification des algorithmes décisionnels classiques, en ce qui concerne le résultat du codage, mais qui optimise le temps de traitement et la surface de silicium.

Ces objectifs, ainsi que d'autres qui apparaîtront par la suite, sont atteints selon l'invention à l'aide d'un procédé de décodage à maximum de vraisemblance d'une séquence d'échantillons correspondant au codage convolutif d'une séquence d'éléments numériques source, du type mettant en oeuvre un algorithme décisionnel du type de l'algorithme de Viterbi, définissant un treillis de décodage initial, constitué d'un ensemble de noeuds correspondant aux états possibles du codage, chaque noeud étant relié à son noeud antécédent direct le plus probable, et consistant à remonter un chemin optimal dans ledit treillis, le procédé comprenant les étapes suivantes :

- sous-échantillonnage dans un rapport p dudit treillis initial, consistant à ne conserver que les noeuds correspondant à un échantillon sur p échantillons consécutifs, et à associer à chacun des noeuds conservés une information identifiant son noeud antécédent d'ordre p dans ledit treillis initial,
- remontée d'un chemin optimal dans le treillis sous-échantillonné, par association à chaque noeud considéré de son noeud antécédent d'ordre p, délivrant une information désignant les deux derniers noeuds dudit chemin optimal,
- sur-échantillonnage dans un rapport p, par association à ladite information désignant les deux derniers noeuds d'une séquence de décodage correspondante, comprenant lesdits derniers noeuds et l'ensemble des p-1 noeuds intermédiaires non conservés lors de ladite étape de sous-échantillonnage,

p étant un entier strictement supérieur à 1, choisi de façon qu'il existe un chemin unique entre un noeud et son antécédent d'ordre p dans ledit treillis initial.

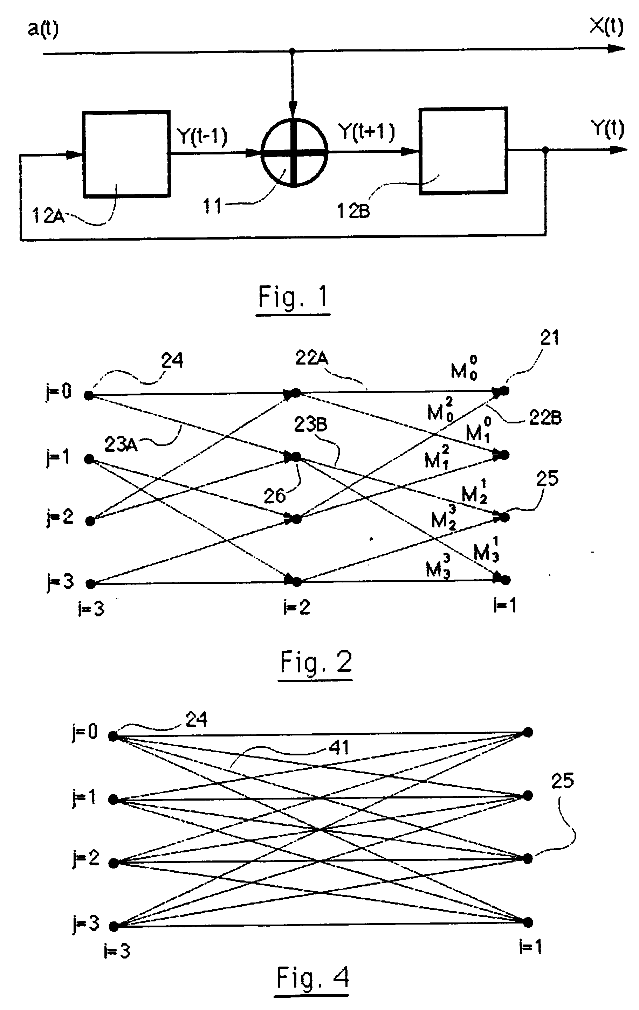

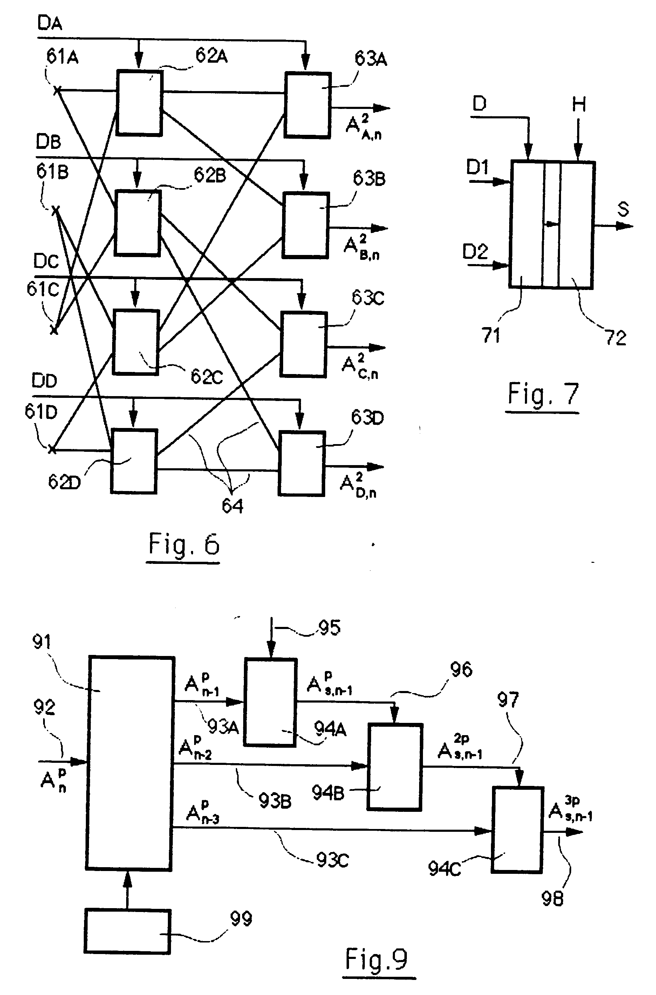

Par noeud antécédent d'ordre p, on entend bien sûr le noeud associé dans le treillis initial (c'est-à-dire le treillis classique, ou usuel), à un noeud donné lorsqu'on effectue une remontée partielle de p-1 noeuds à partir de ce noeud donné. Sur le treillis sous-échantillonné obtenu selon l'invention, ce noeud antécédent d'ordre p devient en fait le noeud antécédent direct, ainsi que cela apparaîtra plus clairement par la suite, en liaison avec les figures 2 et 4.

Le principe à la base de l'invention repose sur l'observation que, dans le treillis initial, une partie de l'information est redondante. En effet, on constate qu'il existe un chemin unique reliant deux noeuds séparés par un, deux, trois noeuds ou plus (selon le code), du fait des interdictions de transition du code convolutif considéré.

Pour effectuer la remontée d'un chemin optimal, il n'est donc pas nécessaire de connaître l'ensemble des noeuds constituant ce chemin optimal, mais uniquement ceux bornant le chemin unique reliant deux noeuds séparés par p-1 noeuds.

On peut donc ne conserver qu'un treillis sous-échantillonné d'un rapport p, sans perte d'information. De cette façon la remontée d'un chemin optimal se fait p fois plus vite.

Avantageusement, ledit procédé est organisé en cycles de décodage, un cycle comprenant au moins une période consécutive, chaque période comprenant les opérations successives suivantes :

- une opération d'écriture, dans ledit treillis sous-échantillonné, des données associées à l'ensemble des noeuds correspondant à un échantillon conservé,
- au moins deux opérations de lecture, dans ledit treillis sous-échantillonné, des données associées à l'ensemble des noeuds correspondant à un échantillon, de façon à effectuer la remontée dudit chemin optimal.

De façon classique, un cycle comprend plusieurs (par exemple 8) périodes consécutives.

Préférentiellement, le rapport entre le nombre d'opérations de lecture et le nombre d'opérations d'écriture est égal à 3 ou 4.

Ainsi, la longueur de troncature (nombre d'échantillons pris en compte pour le décodage) est suffisante, sans que le nombre de lectures à chaque période soit limitatif des performances (en terme de débit) du décodage.

L'invention concerne également un dispositif de décodage mettant en oeuvre le procédé décrit ci-dessus.

Un tel dispositif comprend avantageusement des moyens de sous-échantillonnage dans un rapport p dudit treillis, associant à chacun des noeuds conservés son noeud antécédent d'ordre p, des moyens de mémorisation du treillis sous-échantillonné, et des moyens de sur-échantillonnage des données délivrées par ladite remontée d'un chemin optimal.

Il est à noter que les moyens de mémorisation nécessaires ont une capacité inférieure dans un rapport p à ceux utilisés classiquement, le treillis étant sous-échantillonné dans le même rapport.

De façon préférentielle, lesdits moyens de sous-échantillonnage comprennent un banc de $2^\nu$ registres, $\nu$ étant la longueur de contrainte dudit code convolutif, comprenant chacun p ensemble de $\nu$ bascules, lesdits ensembles de $\nu$ bascules étant interconnectés conformément au modèle défini par ledit treillis initial, de façon que les sorties desdits registres délivrent respectivement l'antécédent d'ordre p de chacun des $2^\nu$ noeuds

correspondant à un échantillon conservé.

On applique ici une technique proche de celle utilisée dans le cas de la méthode par échanges de registres. Toutefois, la taille des registres est réduite à p ensembles de $\nu$ bascules. La surface de silicium nécessaire reste donc peu importante.

Avantageusement, lesdits moyens de mémorisation comprennent une mémoire vive circulaire organisée en mots de $2^\nu.\nu$ bits, où $\nu$ est la longueur de contrainte dudit code convolutif, un mot contenant l'ensemble des informations associées à chacun des noeuds correspondant à un échantillon.

On constate donc que le dispositif de l'invention, dans ce mode de réalisation préférentiel, utilise simultanément des moyens utilisés dans le cas de la méthode par échanges de registres (registres) et des moyens utilisés dans le cas de la méthode par remontée d'un chemin optimal (mémoire circulaire).

Ainsi qu'on le verra par la suite, l'invention regroupe de cette façon les avantages de ces deux méthodes sans en avoir les inconvénients.

Préférentiellement, lesdits moyens de remontée d'un chemin optimal comprennent des moyens d'adressage de ladite mémoire, délivrant un jeu d'au moins deux mots, et des moyens de sélection dans chacun desdits mots de l'information correspondant au noeud appartenant audit chemin optimal.

De façon avantageuse, lesdits moyens de sur-échantillonnage comprennent une table de transcodage, associant à une information désignant les deux noeuds dudit chemin optimal, la séquence de décodage correspondante, comprenant lesdits deux noeuds et l'ensemble des p-1 noeuds intermédiaires non-conservés lors du sous-échantillonnage.

Ainsi, la suite complète des valeurs est effectivement décodée, de façon identique à un décodage obtenu à l'aide d'un treillis classique (mais avec un gain en débit d'un rapport p).

Avantageusement, lesdits moyens de sur-échantillonnage comprennent des moyens de sérialisation, délivrant ladite séquence de décodage à un rythme égal à celui de l'arrivée desdits échantillons.

De cette façon, tout se passe, lorsqu'on observe cette séquence de décodage, comme si l'on avait utilisé un treillis classique.

Ce dispositif peut notamment être implanté sur un circuit intégré. La surface de silicium nécessaire permet d'envisager sans problème la production d'un tel circuit, par exemple en technologie classique CMOS 1μm.

D'autres caractéristiques et avantages de l'invention apparaîtront plus clairement à la lecture suivante d'un mode de réalisation préférentiel de l'invention, donné à titre illustratif et non limitatif, et des dessins annexés, dans lesquels :

- la figure 1 est le schéma de principe d'un codeur convolutif classique, ayant une longueur de contrainte $\nu$ égale à 2 et un rendement de 1/2 ;

- la figure 2 est un treillis des états du codage, représentatif du fonctionnement du codeur de la figure 1 ;
- la figure 3 présente le schéma synoptique d'un décodeur mettant en oeuvre un algorithme du type de l'algorithme de Viterbi ;
- la figure 4 illustre le treillis sous-échantillonné considéré selon l'invention, correspondant au treillis classique de la figure 2 ;
- la figure 5 est un schéma simplifié du module de mémorisation et de remontée du chemin optimal du décodeur de la figure 3 ;
- la figure 6 illustre le principe du module de sous-échantillonnage de la figure 5, selon l'invention ;
- la figure 7 présente un élément de mémoire tel qu'utilisé dans les registres de la figure 6 ;
- la figure 8 présente la structure de la mémoire du décodeur de la figure 5, dans un exemple particulier de l'invention ;
- la figure 9 est un schéma illustrant le fonctionnement de la remontée du chemin optimal selon l'invention ;
- la figure 10 présente la structure du module de sur-échantillonnage de la figure 5.

Le principe de l'invention est illustré ci-dessous à partir d'un code convolutif classique, de longueur de contrainte $v=2$ et de rendement 1/2, obtenu à l'aide d'un codeur tel que représenté en figure 1. Toutefois, il est clair que ce procédé de décodage peut s'appliquer à tous les codes convolutifs de rendement $\eta = M/R$ (M et R entiers, $M \geq 1$ et $R > 1$) quels qu'ils soient, par simple généralisation du procédé décrit, et notamment aux codes usuellement mis en oeuvre dans les codeurs audionumériques et de télévision numériques actuellement développés. Plus généralement, il s'applique dès lors q'uun algorithme décisionnel du type de celui de Viterbi peut être utilisé, que ce soit pour le décodage d'un code convolutif classique ou d'une modulation codée en treillis.

La figure 1 présente donc un codeur qui associe à chaque donnée source a(t) deux valeurs distinctes X(t) et Y(t).

Dans cet exemple, la première valeur X(t) est prise égale à la valeur source a(t). Le codeur met par ailleurs en oeuvre un sommateur modulo 2 (ou exclusif) 11 et un jeu de deux retards $12_A$, $12_B$, qui sont par exemple des bascules D ou les cellules d'un registre à décalage.

Ici, la valeur Y(t) correspond à la sommation 11 de la valeur source a(t-1) avec la valeur Y(t-2), stockée dans le point mémoire $12_A$.

Le fonctionnement de ce codeur peut être décrit par le diagramme du treillis représenté en figure 2. Cette présentation a été proposée par G. D. Forney, dans l'article "The Viterbi algorithm" (Proc. IEEE, mars 1973, 61, n° 3, pp. 268 - 278).

L'algorithme de Viterbi est une technique de décodage qui permet de trouver dans le treillis le chemin à vraisemblance maximale, c'est-à-dire le chemin le plus probable par rapport à celui décrit à l'émission par le codeur.

Chaque noeud 21 du treillis utilisé lors du décodage contient une information sur le chemin survivant, parmi les chemins $22_A$ et $22_B$ aboutissant au noeud 21. Le principe de base de l'algorithme de Viterbi est en effet de ne considérer, en chaque noeud, que le chemin le plus probable, de façon à permettre de remonter aisément le treillis, et donc de déterminer, a posteriori, une estimation de la valeur reçue plusieurs instants de réception auparavant.

Le treillis utilisé au décodage, noté $T(2^v, P)$ a une dimension "verticale" égale au nombre d'états possibles du codeur, soit $2^v$, $v$ étant la longueur de contrainte du code, c'est-à-dire le nombre d'éléments mémoire $13_A$, $13_B$ utilisés lors du codage, et une dimension "horizontale", encore appelée profondeur, notée P. Dans le cas présent, $2^v$ est égal à 4.

Il est clair que l'algorithme est d'autant plus efficace que P est grand, puisque P correspond au nombre d'échantillons reçus pris en compte pour le décodage d'un échantillon donné.

On considère ici le principe théorique de l'algorithme de Viterbi, décodant une donnée à chaque instant de réception. Dans la pratique (ainsi qu'on le verra par la suite), et pour des raisons techniques liées au temps de remontée d'un chemin optimal, un cycle de décodage (incluant une remontée) correspond au décodage de plusieurs données.

Dans ce cas, le treillis a une dimension horizontale totale LT + 2L, où LT est la longueur de troncature, correspondant à la remontée du chemin optimal, et L la longueur sur laquelle on effectue simultanément remontée et décodage.

L'algorithme de Viterbi est notamment décrit dans l'article "Error bounds for convolutional codes and an asymptotically optimum decoding algorithm" (Viterbi A. J., IEEE Trans. IT, USA (nov. 1967), 13, n° 6, pp. 260 - 269).

On rappelle ici, dans le cas classique de la méthode par remontée du chemin optimal ('Trace-Back'), les opérations effectuées dans cet algorithme en une période d'horloge T:

1/ On calcule les distances, encore appelées métriques de transition ou métriques de branche, entre les symboles reçus et les symboles correspondant aux 8 transitions possibles, à savoir :

$$L^0_j = \left| X' - X^0_j \right| + \left| Y' - Y^0_j \right|$$

$$L^1_j = \left| X' - X^1_j \right| + \left| Y' - Y^1_j \right|$$

pour j variant de 0 à 3,
et où :

(X',Y') représente le couple effectivement reçu et échantillonné sur n bits (par exemple n = 4) ;

$X^0_j$ (respectivement $Y^0_j$) représente la valeur X (respectivement Y) considérée sur la transition aboutissant à l'état j et correspondant à une valeur a(t-2) quittant le registre du codeur égale à 0 ;

$X^1_j$ (respectivement $Y^1_j$) représente la valeur X (respectivement Y) considérée sur la transition aboutissant à l'état j et correspondant à une valeur a(t-2) quittant le registre du codeur égale à 1.

Ces valeurs sont généralement calculées sur n bits, le bit de poids fort étant représentatif de la décision et les n-1 bits restants représentant la fiabilité affectée à la décision. Il s'agit donc de décisions pondérées, ou douces.

Cette pondération est utile en particulier quand le code convolutif mis en oeuvre est concaténé avec un ou plusieurs autres codes, tels que par exemple un code du type des codes de Reed-Solomon. En effet, cela permet alors d'informer le décodeur de ce code concaténé de la fiabilité de l'estimation qui lui est transmise.

2/ A chaque état j est associé un additionneur-accumulateur contenant la métrique cumulée $M_j$ telle que :

$$M^0_0(t) = M_0(t-1) + L^0_0(t-1) \; ; \; M^1_0(t) = M_1(t-1) + L^1_0(t-1)$$

$$M^0_1(t) = M_2(t-1) + L^0_1(t-1) \; ; \; M^1_1(t) = M_3(t-1) + L^1_1(t-1)$$

$$M^0_2(t) = M_0(t-1) + L^0_2(t-1) \; ; \; M^1_2(t) = M_1(t-1) + L^1_2(t-1)$$

$$M^0_3(t) = M_2(t-1) + L^0_3(t-1) \; ; \; M^1_3(t) = M_3(t-1) + L^1_3(t-1)$$

$$M_j(t) = \min (M^0_j(t) \; ; \; M^1_j(t))$$

3/ A chaque état j est associé un point mémoire, et l'ensemble du treillis constitue une mémoire de dimension (4, P). Au premier niveau, le contenu $s_j$ du point mémoire associé à l'état j est mis à 0 si $M^0_j(t) \leq M^1_j(t)$, et à 1 si $M^0_j(t) > M^1_j(t)$. $s_j$ est donc directement représentatif du signe de $M^0_j(t) - M^1_j - (t)$ ;

4/ On remonte le chemin mémorisé dans le treillis en partant de l'état pourvu d'une métrique cumulée $M_j$ la plus faible, parmi 4, ou d'une métrique choisie arbitrairement (en principe le chemin converge toujours vers la valeur la meilleure), et en utilisant à chaque niveau de cette remontée le contenu du point mémoire auquel on aboutit, pour choisir entre les deux transitions possibles. Le bit décodé provient alors du point mémoire au niveau i=P, en fin de chemin remonté. Ainsi, à l'instant t, on décode le bit a(t-P) ;

5/ On effectue un décalage complet du treillis et on recommence à la période d'horloge suivante.

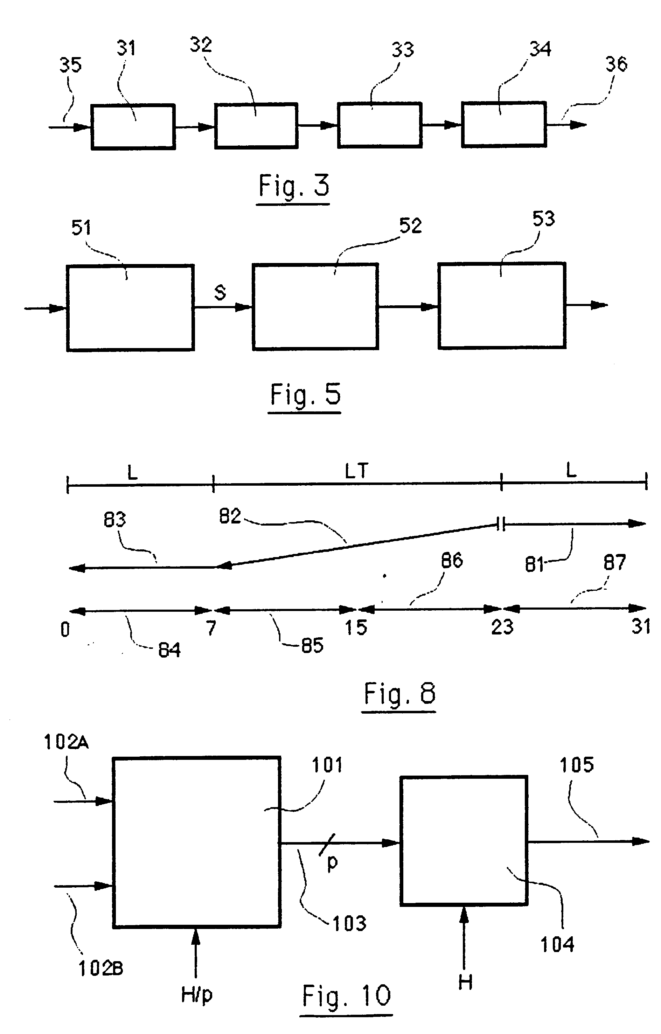

La figure 3 présente le schéma synoptique classique d'un décodeur de Viterbi tel qu'il peut être implanté sur un circuit intégré. Ce décodeur peut se décomposer en quatre grands sous-ensembles consécutifs :

- un calculateur 31 de métriques de branches, ou BMC (en anglo-saxon : Branch Metrics Computer), qui traite des problèmes de formatage des données d'entrée et de calcul des métriques de branches pour chaque métrique d'échantillon reçue 25 (étape 1/ décrite précédemment) ;
- un calculateur 32 de métriques cumulées, ou métriques de chemins, souvent désigné par l'abréviation PMC (en anglo-saxon : Path Metrics Computer) qui pour chaque noeud du treillis ajoute les métriques de branches aux anciennes métriques de chemins, les compare, et sélectionne les nouvelles métriques de chemin optimales. Ces différentes fonctions sont généralement résumées par le terme ACS (en anglo-saxon : Add-Compare-Select (Addition-Comparaison-Sélection)) (étape 2/) ;
- un module 33 de mémorisation des survivants et de mise à jour, ou SSU (en anglo-saxon : Survivors Storage and Updating) qui stocke les décisions (encore appelées "survivants") issues des ACS et "remonte" les chemins de façon cyclique (remontée des survivants), (étapes 3/ à 5/) ;
- un module 34 de sortie, ou OD (Output Device, en anglo-saxon), assurant le reformatage en sortie des données décodées 36.

Ainsi qu'on l'a déjà mentionné en préambule, deux méthodes sont classiquement utilisées pour la réalisation du module 33 de mémorisation et de mise à jour.

La première méthode, dite méthode par remontée du chemin optimal, repose sur l'utilisation d'une mémoire RAM classique pour mémoriser les métriques de chemin. Elle nécessite un grand nombre d'accès à cette mémoire (écriture des décisions et remontée du chemin, qui doivent être effectuées simultanément), qui limite le débit utile du décodeur.

La seconde méthode (par échanges de registres) ne nécessite pas la remontée systématique du chemin optimal. En effet, elle associe à chacun des états du treillis un registre à décalage qui contient toute l'information sur le chemin conduisant à cet état.

Ce mode de gestion nécessite de nombreux échanges de données entre les différents registres mais pas de montée comme dans la première méthode, car chaque registre contient toute l'information sur le chemin conduisant à cet état.

C'est pourquoi le mode par échanges de registres peut être utilisé pour les fréquences d'horloges plus élevées.

Cependant, les interconnexions entre les différents registres, dont le nombre est proportionnel au nombre d'états du treillis et la taille proportionnelle à la longueur de troncature choisie, augmentent notablement la surface du circuit. De plus, un registre a une surface plus importante (au moins multipliée par 3) qu'un point mémoire d'une RAM .

L'invention propose une solution intermédiaire entre ces deux méthodes connues, cumulant leurs avantages et limitant leurs inconvénients.

Le principe de l'invention repose notamment sur l'observation qu'un treillis classique, tel qu'illustré en figure 2, présente des redondances, compte-tenu des interdictions dans les transitions entre états (ces transitions sont fonction, et représentatives, du code utilisé) . Ainsi, par exemple, on constate qu'il n'existe qu'un chemin unique ($23_A$, $23_B$) joignant les noeuds 24 et 25. En d'autres termes, le chemin ($23_A$, $23_B$) est complètement défini par ses bornes 24 et 25 : il n'est pas nécessaire de connaître le noeud intermédiaire 26.

Il apparaît donc que le treillis de la figure 2 est équivalent à celui illustré en figure 4, en ce qui concerne la remontée d'un chemin. Par exemple, le chemin 41 est équivalent au chemin ($23_A$, $23_B$).

Bien sûr, lors du décodage, il est nécessaire de savoir que le chemin reliant les points 24 et 25 passe en réalité par le noeud 26. Toutefois, cette information est figée, et peut donc être mémorisée une fois pour toutes. Le mécanisme correspondant est décrit par la suite, en liaison avec la figure 10.

En d'autres termes, il est donc possible d'effectuer, sans perte d'information, un sous-échantillonnage du treillis classique. Ainsi, la remontée du chemin optimal peut être effectuée, dans l'exemple décrit, deux fois plus vite.

Dans d'autres cas, en fonction des besoin et du code considéré, le sous-échantillonnage peut être d'un noeud sur trois ou sur quatre, voire plus. Par exemple, il suffit, lorsqu'on utilise un code de rendement R = 1/2 et que $\nu$ = 4, de connaître un état sur quatre pour pouvoir reconstituer la chaine.

La figure 5 présente un schéma synoptique général du module 33 du décodeur de la figure 3, dans le cas de l'invention. Ce module de mémorisation et de remontée comprend :

- des moyens 51 de sous-échantillonnage du treillis ;
- des moyens 52 de stockage du treillis sous-échantillonné et de remontée;
- des moyens 53 de sur-échantillonnage, permettant de restituer toutes les données.

Selon l'invention, les moyens 51 de sous-échantillonnage sont à base de registres, et fonctionne sur le principe général de la technique dite à échanges à registres. Ils délivrent une suite S des états précédents, pour chaque chemin arrivant à un état donné, sous-échantillonné d'un rapport p. Le fonctionnement du module 51 est précisé plus en détail par la suite, en liaison avec la figure 6.

Cela permet de définir un treillis 52 classique, mais sous-échantillonné, dans lequel la remontée du chemin optimal peut être effectuée de façon similaire à celle mise en oeuvre dans la méthode dite "Trace Back", mais beaucoup plus rapide.

Il est à noter toutefois, que, contrairement aux méthodes de remontée classiques, chaque noeud ne contient pas une information désignant le chemin optimal permettant de l'atteindre (chemin survivant), mais une information repérant son noeud antécédent d'ordre p.

Ainsi, la surface de silicium reste peu importante (par rapport au mode par échanges de registres), les registres utilisés étant de petite taille et la mémoire RAM de taille réduite d'un facteur p, et la rapidité de traitement est augmentée du même facteur p.

En d'autres termes, la philosophie sous-jacente à ce nouveau système de gestion des survivants est d'utiliser le mode dit "Registre Exchange" comme un "turbo", permettant de doubler, voire de quadrupler la vitesse de remontée des survivants en mode dit "Trace-Back", ce qui lui permettra de traiter des débits beaucoup plus élevés.

La figure 6 présente la structure des moyens 51 de sous-échantillonnage dans le cas simple du treillis de la figure 2 ($\nu$ = 2). Le but de ces moyens est d'indiquer, pour chaque noeud considéré, de quel noeud est issu le survivant p cycles auparavant, appelé par la suite antécédent d'ordre p. D'une manière générale, on notera $A^p_{s,n}$ l'antécédent d'ordre p du survivant au noeud s et à l'instant nT.

A chacun des quatre états $61_A$ à $61_B$ considérés à chaque symbole reçu est associé un registre de deux bascules, respectivement $62_A$ à $62_D$ et $63_A$ à $63_D$, pour le stockage du noeud antécédent d'ordre 1, soit $A^1_{s,n}$, et du noeud antécédent d'ordre 2, soit $A^2_{s,n}$.

La structure d'un de ces bascules est présentée plus en détail en figure 7. Il comprend un multiplexeur 71, qui sélectionne une des deux données S1, S2 présentes à son entrée, en fonction de la décision D délivrée par le module 32 (figure 3). Le multiplexeur 71 est couplé à une bascule D 72, pilotée par une horloge H fonctionnant au rythme des données (temps cycle), qui délivre la donnée $S = DS_1 + \overline{D}S_2$.

Chaque registre a une taille de $\nu$ bits (ici $\nu$ = 2).

D'une manière plus générale, lorsqu'il suffit de connaître un état sur p pour pouvoir reconstituer la chaîne (antécédent d'ordre p) on aura pour chacun des $2^\nu$ états du treillis un registre de p x $\nu$ bascules permettant de délivrer les antécédents d'ordre p.

La surface occupée sur le silicium est donc faible, par rapport à la méthode par échanges de registres, qui nécessite $2^\nu$ registres de LT (longueur de troncature) bascules.

De façon similaire à cette méthode par échanges de registres, les bascules $62_A$ à $62_D$ et $63_A$ à $63_D$ sont interconnectées (64), selon le modèle de treillis (voir figure 2) correspondant au code convolutif utilisé.

Tous les deux temps cycle, ce module 51 délivre les $2^v$ antécédents d'ordre 2 (plus généralement, dans le cas d'un sous-échantillonnage de rang P, chaque registre comprend $pxv$ bascules et délivre tous les p temps cycle l'antécédent d'ordre p), qui sont mémorisés, puis relus dans le sens inverse (remontée) et décodés, conformément à la méthode classique de remontée d'un chemin optimal.

Toutefois, grâce au sous-échantillonnage, on dispose de p fois plus de temps pour effectuer les différentes opérations (notamment les lectures de remontée). Inversement, pour un volume d'informations à traiter donné, le débit peut être p fois plus élevé.

Avant de décrire le mécanisme de remontée du chemin optimal selon l'invention, on rappelle la structure classique d'une mémoire RAM, dans le cas de la méthode à remontée de chemin, en liaison avec la figure 8.

La mémoire peut être compartimentée en trois zones :

- une zone 81 d'inscription des décisions issues du module 32 (figure 3) ;
- une zone 82 de remontée du chemin optimal ;
- une zone 83 de remontée et de décodage.

Cette mémoire fonctionne circulairement, les zones 81, 82, 83 se décalant à chaque période de décodage.

A chaque periode, le traitement comprend donc une inscription (81) de L décisions.

De façon que le flux de données entrant soit égal au flux de données sortant, il faut bien sûr que le nombre de données décodées (83) soit aussi égal à L.

La remontée d'un chemin optimal se fait donc sur LT + L, ou LT est la longueur de troncature. La remontée consiste donc en une remontée sans décodage (82), puis une remontée avec décodage (83). Il est clair que plus la longueur de troncature est grande, meilleure est la convergence du chemin optimal.

On a donc, selon cette méthode, un rapport R = (LT + L)/L entre le nombre de lectures et le nombre d'écritures à effectuer. Classiquement, R est choisi égal à 3 ou 4, voire plus si la technologie ou le débit le permet. Plus R est grand, plus la longueur de troncature est grande, et par conséquence, meilleure est la qualité du décodage, sans que la taille de la mémoire soit augmentée.

La figure 9 présente le mécanisme de remontée d'un chemin optimal, dans le cas d'un rapport lectures/écritures R = 3.

Les données délivrées par le module de la figure 6 sont stockées dans une mémoire 91 de 2LT (LT + L + L, avec L = LT/2) mots de chacun $v.2^v$ bits. Chaque mot comprend en effet les $2^v$ antécédents d'ordre p correspondant aux $2^v$ états possibles du codage, codés chacun sur v bits.

A un instant donné nT, des moyens 99 d'adressage de la mémoire effectuent donc une écriture 92 d'un mot $AP_n$ correspondant aux antécédents déterminés par le module 51, puis on réalise trois lectures $93_A$, $93_B$, $93_C$ successives des mots précédents $AP_{n-1}$, $AP_{n-2}$ et $AP_{n-3}$, qui sont délivrés respectivement à trois modules de sélection $94_A$ à $94_C$, ou multiplexeurs.

Ainsi qu'on l'a déjà mentionné, l'information inscrite désigne un noeud du treillis (noeud antécédent d'ordre p). Au contraire, selon la méthode classique de remontée du chemin optimal, c'est un chemin (le suivant) qui est mémorisé. Du fait du sous-échantillonnage, il n'est plus possible (sans adaptation) d'utiliser cette méthode.

Le premier module de sélection $94_A$ est piloté par une information 95, qui désigne le noeud origine du chemin optimal à remonter. Il peut par exemple s'agir du noeud présentant la métrique cumulée la plus faible, ou d'un noeud choisi arbitrairement (dans tous les cas, il y a en principe convergence vers le chemin optimal).

Ce module $94_A$ délivre (96) donc l'antécédent d'ordre p $AP_{s,n-1}$, du noeud d'origine, qui pilote le second module de sélection $94_B$. Ce module délivre (97) à son tour l'antécédent d'ordre p du noeud $AP_{s,n-1}$, soit l'antécédent d'ordre 2p $(A^{2p}_{s,n-1})$ du noeud désigné par l'information 95.

Enfin, le dernier module de sélection $94_c$ délivre (98) le noeud $A^{3p}_{s,n-1}$, qui est l'antécédent d'ordre 3p du noeud origine du chemin optimal.

Ainsi, en trois opérations de lecture, il est possible d'associer à un noeud d'origine son antécédent d'ordre 3p.

A titre d'exemple, on décrit plus précisément le fonctionnement de ce système dans le cas d'un code convolutif classiquement utilisé, de longueur de contrainte $v = 6$ et de rendement 1/2, pour lequel il est suffisant de connaître un état sur quatre dans le treillis pour remonter un chemin.

Dans ce cas, le module 51 (figure 5) délivre les antécédents d'ordre 4 des états considérés. (Il serait également possible, bien sûr, que ce module 51 ne délivre que les antécédents d'ordre 2, si un doublement de la vitesse de remontée est suffisant).

Les mots délivrés par ce module 51 comprennent les 64 ($2^v$) antécédents d'ordre 4. Ils sont donc constitués de $v.64 = 384$ bits, et sont délivrés tous les 4 temps cycle.

On considère le cas d'un décodeur présentant une longueur de troncature LT égale à 64, avec un rapport entre lectures et écritures R = 3.

La mémoire doit donc avoir une capacité de stockage de 2LT/4, soit 32 mots, puisque seulement un état sur quatre est mémorisé.

Cette mémoire se comporte comme un registre circulaire, et peut être partagée en 4 secteurs de 8 mots (figure 8) :

- premier secteur 84 : adresses de 0 à 7 ;
- deuxième secteur 85 : adresses de 8 à 15 ;

- troisième secteur 86 : adresses de 16 à 23 ;
- quatrième secteur 87 : adresses de 24 à 31.

Un cycle complet de décodage dure 8 périodes de chacune 4 temps cycle.

Si, par exemple, le compteur d'adresse d'écriture est à l'adresse 24 (début du quatrième secteur 87) à l'instant n, la première période consiste en les opérations suivantes :

- écriture de $A^4_n$ à l'adresse 24, soit le début du 4ème secteur 87 ;
- lecture de $A^4_{n-1}$ à l'adresse 23, soit la fin du 3ème secteur 86, et sélection (96, figure 9) de $A^4_{0,n-1}$ (on fixe ici systématiquement le noeud 0 comme origine du chemin optimal) ;
- lecture de $A^4_{n-2}$ à l'adresse 22 et sélection (97) de $A^8_{0,n-1}$, l'antécédent d'ordre 4 de $A^4_{0,n-1}$ ;
- lecture de $A^4_{n-3}$ à l'adresse 21 et sélection de $A^{12}_{0,n-1}$.

La procédure se poursuit ainsi, avec toujours un rapport 3 entre écriture et lecture. La huitième et dernière période comprend donc :

- écriture à l'adresse 31 de $A^4_{n+7}$ ;
- lecture à l'adresse 2 de $A^4_{n-22}$ et sélection de $A^{88}_{0,n-1}$ ;
- lecture à l'adresse 1 de $A^4_{n-23}$ et sélection de $A^{92}_{0,n-1}$ ;
- lecture à l'adresse 0 de $A^4_{n-24}$ et sélection de $A^{96}_{0,n-1}$ ;

Au cycle suivant, l'écriture se fait à l'adresse 0 et une nouvelle procédure de remontée des survivants est lancée à partir de l'adresse 31.

Pour chaque remontée des survivants les huit dernières lectures sont stockées dans une mémoire tampon LIFO (Last In First Out : Dernier entré premier sorti) et relues au rythme d'un noeud tous les 4 temps cycles de façon à régénérer un flot de données continues à destination de la mémoire de décodage.

Un mode de réalisation de ce module 53 est illustré en figure 10.

Il est en effet nécessaire de fournir, en sortie du décodeur, l'ensemble des valeurs décodées, et non seulement la suite sous-échantillonnée dans un rapport p des états du système.

On a vu toutefois que le rapport de sous-échantillonnage p est choisi de façon qu'il y ait un chemin unique entre deux noeuds consécutifs. Il est donc aisé, connaissant ces deux noeuds, de reconstituer la suite complète à l'aide d'une simple table.

Le module de sur-échantillonnage comprend donc une mémoire de décodage ROM ("Read Only Memory"; Mémoire morte) 101 qui contient une table associant au couple noeud de départ $102_A$ - noeud d'arrivée $102_B$ la séquence 103 complète des p noeuds compris entre les noeuds de départ et d'arrivée.

Cette séquence est délivrée tous les p temps cycle, c'est-à-dire au rythme d'une horloge H/P, H définissant le temps cycle.

Elle est dirigée vers un sérialisateur 104, qui fonctionne au rythme de l'horloge H, et délivre successivement les données 105 représentatives des décisions du décodage. Ainsi, pour le module 34 (figure 3) de sortie, les données sont présentées de façon identique à ce qu'elles seraient dans le cas d'un décodeur à remontée d'un chemin optimal classique.

Pourtant, la vitesse de fonctionnement a été accrue d'un facteur p, et la surface de silicium nécessaire reste tout à fait acceptable.

En effet, dans l'exemple décrit précédemment du décodage d'un code convolutif à longueur de contrainte $\nu = 6$ et rendement 1/2, la mémoire de 32 mots de 384 bits occupe, en technologie CMOS 1μm, environ $15 mm^2$.

L'ensemble du circuit, comprenant les registres du module de sous-échantillonnage, la mémoire de 32 mots, la mémoire tampon (LIFO) et la mémoire morte de décodage, occupe alors une surface inférieure à 50 $mm^2$.

Cela représente un gain très important par rapport à la surface nécessaire à un décodeur classique par échanges de registres équivalent. En effet, la mise en oeuvre de la gestion des survivants nécessite alors 64 registres de 64 bascules soit 4 100 bascules ce qui représente au moins 41 000 portes logiques, soit une surface de 41 $mm^2$ à raison de 1000 portes/$mm^2$ en technologie CMOS 1μm.

On estime généralement que les interconnexions doublent la surface, ce qui la porte à 80 $mm^2$.

Dans le cas où utiliser simplement un rapport 2 est suffisant, la partie registres nécessitant 2 fois moins de bascules occupe simplement 15 $mm^2$. Par contre, la mémoire RAM circulaire, étant pour la même longueur de troncature constituée de 64 mots de 384 bits, occupe environ 30 $mm^2$. La surface totale sera donc pratiquement la même.

Le nouveau mode de gestion des survivants selon l'invention permet donc de traiter des débits très élevés, tout en nécessitant une surface de circuit plus faible que le mode par échanges de registres.

Il peut être utilisé par tout circuit mettant en oeuvre l'algorithme de Viterbi, en décodant aussi bien des codes convolutifs (par exemple pour la diffusion audionumérique DAB) que des modulations codées en treillis (MCT) (par exemple pour la télévision numérique).

**Revendications**

1. Procédé de décodage à maximum de vraisemblance d'une séquence d'échantillons (35) correspondant au codage convolutif d'une séquence d'éléments numériques source, du type mettant en oeuvre un algorithme décisionnel du type de l'algorithme de Viterbi, définissant un treillis de décodage initial, constitué d'un ensemble de noeuds (21, 24, 25, 26) correspondant aux états possibles du codage, chaque noeud (25) étant relié à son noeud antécédent direct le plus probable (26), et consistant à remonter un chemin optimal ($23_A$, $23_B$) dans ledit treillis,
caractérisé en ce qu'il comprend les étapes suivantes :

- sous-échantillonnage (51) dans un rapport p dudit treillis initial, consistant à ne conserver que les noeuds (24, 25) correspondant à un échantillon sur p échantillons consécutifs, et à associer à chacun des noeuds (25) conservés une information identifiant son noeud antécédent d'ordre p(24) dans ledit treillis initial,
- remontée (52) d'un chemin optimal (41) dans le treillis sous-échantillonné, en associant à chaque noeud considéré (25) le noeud antécédent d'ordre p (24), délivrant une information ($102_A$, $102_B$) désignant les deux derniers noeuds dudit chemin optimal,
- sur-échantillonnage (53 ; 101) dans un rapport p, en associant à ladite information ($102_A$, $102_B$) désignant les deux derniers noeuds dudit chemin optimal une séquence de décodage correspondant auxdits deux derniers noeuds ainsi qu'à l'ensemble des p-1 noeuds intermédiaires (26) non conservés lors de ladite étape de sous-échantillonnage (51),

p étant un entier strictement supérieur à 1, choisi de façon qu'il existe un chemin unique (41 ; $23_A$, $23_B$) entre un noeud (25) et son antécédent d'ordre p (24) dans ledit treillis initial.

2. Procédé de décodage selon la revendication 1, caractérisé en ce qu'il est organisé en cycles de décodage, un cycle comprenant au moins une période consécutive, chaque période comprenant les opérations successives suivantes :

- une opération d'écriture (81), dans ledit treillis sous-échantillonné, des données associées à l'ensemble des noeuds correspondant à un échantillon conservé,
- au moins deux opérations de lecture (82, 83), dans ledit treillis sous-échantillonné, des données associées à l'ensemble des noeuds correspondant à un échantillon, de façon à effectuer la remontée dudit chemin optimal.

3. Procédé de décodage selon la revendication 2, caractérisé en ce que le rapport entre le nombre d'opérations de lecture (81) et le nombre d'opérations d'écriture (82, 83) est égal à 3 ou 4.

4. Dispositif de décodage à maximum de vraisemblance d'une séquence d'échantillons (35) correspondant au codage convolutif d'une séquence d'éléments numériques source, du type mettant en oeuvre un algorithme décisionnel du type de l'algorithme de Viterbi, définissant un treillis de décodage initial, constitué d'un ensemble de noeuds (21, 24, 25, 26) correspondant aux états possibles du codage, chaque noeud (25) étant relié à son noeud antécédent direct le plus probable (26), et consistant à remonter un chemin optimal ($23_A$, $23_B$) dans ledit treillis,
caractérisé en ce qu'il comprend :

- des moyens (51) de sous-échantillonnage dans un rapport p dudit treillis, associant à chacun des noeuds conservés (25) son noeud antécédent d'ordre p (24) ;
- des moyens (91) de mémorisation du treillis sous-échantillonné ;
- des moyens de remontée (52) d'un chemin optimal (41) dans le treillis sous-échantillonné, associant à chaque noeud considéré (25) le noeud antécédent d'ordre p(24), et délivrant une information ($102_A$, $102_B$) désignant les deux derniers noeuds dudit chemin optimal ; et
- des moyens (53 ; 101) de sur-échantillonnage dans un rapport p des données délivrées par lesdits moyens de remontée d'un chemin optimal,, associant à ladite information ($102_A$, $102_B$) désignant les deux derniers noeuds dudit chemin optimal une séquence de décodage correspondant auxdits deux derniers noeuds ainsi qu'à l'ensemble des p-1 noeuds intermédiaires (26) non conservés lors du sous-échantillonnage (51), p étant un entier strictement supérieur à 1, choisi de façon qu'il existe un chemin unique (41 ; $23_A$, $23_B$) entre un noeud (25) et son antécédent d'ordre p (24) dans ledit treillis initial.

5. Dispositif selon la revendication 4, caractérisé en ce que lesdits moyens de sous-échantillonnage (51) comprennent un banc de $2^\nu$ registres, $\nu$ étant la longueur de contrainte dudit code convolutif, comprenant chacun p ensemble de v bascules ($62_A$ à $62_D$, $63_A$ à $63_D$), lesdits ensembles de v bascules étant interconnectés (64) conformément au modèle défini par ledit treillis initial, de façon que les sorties desdits registres délivrent respectivement l'antécédent d'ordre p ($A^2_{A,n}$ à $A^2_{D,n}$) de chacun des $2^\nu$ noeuds correspondant à un échantillon conservé.

6. Dispositif selon l'une des revendications 4 et 5, caractérisé en ce que lesdits moyens de mémorisation comprennent une mémoire vive circulaire (91) organisée en mots de $2^\nu . \nu$ bits, où $\nu$ est la longueur de contrainte dudit code convolutif, un mot contenant l'ensemble des informations associées à chacun des noeuds correspondant à un échantillon.

7. Dispositif selon la revendication 6, caractérisé en ce que lesdits moyens de remontée d'un chemin optimal comprennent des moyens (99) d'adressage de ladite mémoire (91), délivrant un jeu d'au moins deux mots ($93_A$ à $93_C$), et des moyens ($94_A$ à $94_C$) de sélection dans chacun desdits mots de l'information (96, 97, 98) correspondant au noeud appartenant audit chemin optimal.

8. Dispositif selon l'une quelconque des revendications 4 à 7, caractérisé en ce que lesdits moyens (53) de sur-échantillonnage comprennent une table (101) de transcodage, associant à une information ($102_A$, $102_B$) désignant les deux noeuds dudit chemin optimal, la séquence de décodage (103) correspondant auxdits deux noeuds et à l'ensemble des p-1 noeuds intermédiaires non-conservés lors du sous-échantillonnage.

9. Dispositif selon la revendication 8, caractérisé en ce que lesdits moyens (53) de sur-échantillonnage comprennent des moyens (104) de sérialisation, délivrant (105) ladite séquence de décodage (103) à un rythme égal à celui de l'arrivée desdits échantillons.

10. Dispositif selon l'une quelconque des revendications 4 à 9, caractérisé en ce qu'il est implanté dans un circuit intégré.

**Patentansprüche**

1. Verfahren zum Dekodieren einer Folge abgetasteter Daten (35) mit höchster Wahrscheinlichkeit die der faltenden Kodierung einer Folge digitaler Quellenelemente entspricht, welche einen Entscheidungsalgorithmus von der Art des Viterbi-Algorithmus anwendet; das Verfahren definiert ein anfängliches Dekodierungsgitter, bestehend aus einer Menge von Knoten (21, 24, 25, 26), die den möglichen Kodierungszuständen entsprechen, wobei jeder Knoten mit seinem wahrscheinlichsten direkt vorhergehenden Knoten (26) verbunden ist; ferner besteht das Verfahren darin, das ein optimaler Weg ($23_A$, $23_B$) im Gitter nachgegangen wird, gekennzeichnet durch folgende Verfahrensschritte:

- Unterabtastung (51) in einem Verhältnis p des Ausgangsgitters, darin bestehend, daß nur die Knoten (24, 25) beibehalten werden, welche einem abgetasteten Wert aus p aufeinanderfolgenden abgetasteten Werten entsprechen und darin, daß jedem der beibehaltenen Knoten (25) eine Information zugeordnet wird, die den vorausgehenden Knoten der Ordnung p(24) im Ausgangsgitter identifiziert,
- Verfolgung (52) eines optimalen Weges (41) im unterabgetasteten Gitter, wobei jedem betrachteten Knoten (25) der vorausgehende Knoten der Ordnung p(24) zugeordnet wird, wobei eine Information ($102_A$, $102_B$) bereitgestellt wird, welche die zwei letzten Knoten des optimalen Weges kennzeichnet,
- Überabtastung (53; 101) in einem Verhältnis p, wobei der Information ($102_A$, $102_B$), welche die zwei letzten Knoten des optimalen Weges kennzeichnet, eine Dekodierungsfolge zugeordnet wird, die diesen zwei letzten Knoten des optimalen Weges sowie der Menge der p-1 beim Unterabtastungsschritt (51) nicht beibehaltenen dazwischenliegenden Knoten (26) entspricht,

dabei ist p eine ganze Zahl, die streng größer als 1 ist und so gewählt wird, daß es einen einzigen Weg (41; $23_A$, $23_B$) zwischen einem Knoten (25) und dem vorausgehenden der Ordnung p(24) im Ausgangsgitter gibt.

2. Verfahren gemäß Anspruch 1, dadurch gekennzeichnet, daß es in Dekodierzyklen organisiert ist, wobei ein Zyklus mindestens eine nachfolgende Periode umfaßt und wobei jede Periode die folgenden sukzessiven Operationen umfaßt:

- eine Schreiboperation (81) im unterabgetasteten Gitter der Daten, die der Menge der Knoten zugeordnet sind, welche einem beibehaltenen abgetasteten Wert entsprechen,
- mindestens zwei Leseoperationen (82, 83) im unterabgetasteten Gitter der Daten, die der Menge der Knoten zugeordnet sind, welche einem Muster entsprechen, um die Verfolgung des optimalen Weges sicherzustellen.

3. Verfahren gemäß Anspruch 2, dadurch gekennzeichnet, daß das Verhältnis zwischen der Zahl der Leseoperationen (81) und der Zahl der Schreiboperationen (82, 83) 3 oder 4 beträgt.

4. Vorrichtung zum Dekodieren einer Folge abgetasteter Daten (35) mit höchster Wahrscheinlichkeit, die der faltenden Kodierung einer Folge digitaler Quellenelemente entspricht, welche einen Entscheidungsalgorithmus von der Art des Viterbialgorithmus anwendet; das Verfahren definiert ein anfängliches Dekodierungsgitter, bestehend aus einer Menge von Knoten (21, 24, 25, 26), die den möglichen Kodierungszuständen entsprechen, wobei jeder Knoten mit seinem wahrscheinlichsten direkt vorhergehenden Knoten (26) verbunden ist; ferner besteht das Verfahren darin, daß ein optimaler Weg ($23_A$, $23_B$) im Gitter nachgegangen wird, dadurch gekennzeichnet, daß es die folgenden Schritte umfaßt:

- Mittel (51) zum Unterabtasten des Gitters im Verhältnis p, wobei jedem der beibehaltenen Knoten (25) sein vorhergehender Knoten der Ordnung p(24) zugeordnet wird,
- Mittel (91) zum Speichern des unterabgetasteten Gitters;
- Mittel zum Verfolgen (52) eines optimalen Weges (41) im unterabgetasteten Gitter, wobei jedem betrachteten Knoten (25) der vorhergehende Knoten der Ordnung p(24) zugeordnet ist, und wobei eine Information ($102_A$, $102_B$) bereitgestellt wird, welche die zwei letzten Knoten des optimalen Weges kennzeichnet und
- Mittel (53; 101) zum Überabtasten im Verhältnis p der Daten, die von den Mitteln zum Folgen des optimalen Weges bereitgestellt wurden, wobei der Information ($102_A$, $102_B$), welche die zwei letzten Knoten des optimalen Weges kennzeichnet, eine Dekodierfolge zugeordnet wird, welche diesen zwei letzten Knoten sowie der Menge der p-1 zwischenliegenden Knoten (26), die bei der Unterabtastung (51) nicht beibehalten wurden, entspricht; dabei ist p eine ganze Zahl, die streng größer als 1 und so gewählt wird, daß es einen einzigen Weg (41; $23_A$, $23_B$) zwischen einem Knoten (25) und dem vorausgehenden der Ordnung p(24) im Ausgangsgitter gibt.

5. Vorrichtung gemäß Anspruch 4,
dadurch gekennzeichnet, daß die Mittel zur Unterabtastung (51) eine Bank von $2^v$ Registern umfassen, wobei v die Bedingungslänge des faltenden Codes ist, welche jeweils p Mengen von v Kippschaltungen ($62_A$ bis $62_D$, $63_A$ bis $63_D$) umfassen, wobei die Gruppen von v Kippschaltungen gemäß des durch das Anfangsgitter definierten Modells derart untereinander geschaltet sind (64), daß die Ausgänge dieser Register jeweils den vorausgehenden Wert der Ordnung p($A^2_{A,n}$ bis $A^2_{D,n}$) eines jeden der $2^v$ Knoten bereitstellen, die einem beibehaltenen abgetasteten Wert entsprechen.

6. Vorrichtung gemäß einem der Ansprüche 4 und 5,
dadurch gekennzeichnet, daß die Mittel zum Speichern einen kreisförmigen Arbeitsspeicher (91) umfassen, der in Wörtern von $2^v \cdot v$ Bits organisiert ist, wobei v die Bedingungslänge des faltenden Codes ist und wobei ein Wort die Menge der Informationen umfaßt, die jedem der Knoten zugeordnet sind, welche einem abgetasteten Wert entsprechen.

7. Vorrichtung gemäß Anspruch 6,
dadurch gekennzeichnet, daß die Mittel zum Verfolgen des optimalen Weges Mittel (99) zum Adressieren des Speichers (91) umfassen, welche einen Satz von mindestens zwei Wörtern ($93_A$ bis $93_C$) bereitstellen sowie Selektionsmittel ($94_A$ bis $94_C$) in jedem der Informationswörter (96, 97, 98), welche dem Knoten entsprechen, der dem optimalen Weg angehört.

8. Vorrichtung gemäß einem der Ansprüche 4 bis 7,
dadurch gekennzeichnet, daß die Mittel (53) zur Überabtastung eine Transkodiertabelle (101) umfassen, die einer Information ($102_A$, $102_B$), welche die zwei Knoten des optimalen Weges kennzeichnet, die Dekodierfolge (103) zuordnet, welche den zwei Knoten und der Menge der p-1 zwischenliegenden, bei der Unterabtastung nicht beibehaltenen Knoten entspricht.

9. Vorrichtung gemäß Anspruch 8,
dadurch gekennzeichnet, daß die Mittel (53) zum Überabtasten Mittel (104) zum Serialisieren umfassen, welche die Dekodierfolge (105) im gleichen Rhythmus bereitstellen, wie die abgetasteten Werte ankommen.

10. Vorrichtung gemäß einem der Ansprüche 4 bis 9,
dadurch gekennzeichnet, daß sie in einem integrierten Schaltkreis eingebaut ist.

**Claims**

1. Method for the maximum likelihood decoding of a sequence of samples (35) corresponding to the convolutional coding of a sequence of digital source elements, of the type implementing a Viterbi algorithm type of decision algorithm, defining an initial decoding trellis, constituted by a set of nodes (21, 24, 25, 26) corresponding to the possible states of the coding, each node (25) being connected to its most probable direct antecedent node (26), and consisting in tracing back an optimum path ($23_A$, $23_B$) in said trellis, characterized in that it comprises the following steps:

- sub-sampling (51), by a ratio p, of said initial trellis, consisting in preserving only the nodes (24, 25) corresponding to one sample out of p consecutive samples and in associating, with each of the nodes (25) preserved, an information element identifying its p order antecedent node (24) in said initial trellis,
- tracing back (52) an optimum path (41) in the sub-sampled trellis, by the association, with each node considered (25), of the p order antecedent node (24), delivering an information element ($102_A$, $102_B$) designating the last two nodes of said optimum path,

- over-sampling (53; 101), by a ratio p, by associating with said information element ($102_A$, $102_B$) designating the last two nodes of said optimum path, a decoding sequence corresponding to said last two nodes as well as to the set of p-1 intermediate nodes (26) not preserved during said sub-sampling step (51),

p being an integer strictly greater than 1, chosen so that there is a single path (41; $23_A$, $23_B$) between a node (25) and its p order antecedent (24) in said initial trellis.

2. Decoding method according to Claim 1, characterized in that it is organized in decoding cycles, a cycle comprising at least one consecutive period, each period comprising the following successive operations:

- an operation (81) for the writing, in said sub-sampled trellis, of the data elements associated with the set of nodes corresponding to a preserved sample,
- at least two operations (82, 83) for the reading, in said sub-sampled trellis, of the data elements associated with the set of nodes corresponding to a sample, so as to carry out the trace-back of said optimum path.

3. Decoding method according to Claim 2, characterized in that the ratio between the number of reading operations (81) and the number of writing operations (82, 83) is equal to 3 or 4.

4. Device for the maximum likelihood decoding of a sequence of samples (35) corresponding to the convolutional coding of a sequence of digital source elements, of the type implementing a Viterbi algorithm type of decision algorithm, defining an initial decoding trellis, constituted by a set of nodes (21, 24, 25, 26) corresponding to the possible states of the coding, each node (25) being connected to its most probable direct antecedent node (26), and consisting in tracing back an optimum path ($23_A$, $23_B$) in said trellis,
characterized in that it comprises:

- means (51) of sub-sampling, by a ratio p, the said trellis, associating, with each of the nodes (25) preserved, its p order antecedent node (24);
- means (91) for memorizing the sub-sampled trellis;
- means (52) for tracing back an optimum path (41) in the sub-sampled trellis, by the association, with each node considered (25), of the p order antecedent node (24), and delivering an information element ($102_A$, $102_B$) designating the last two nodes of said optimum path;

- means (53; 101) for over-sampling, by a ratio p, the data delivered by said means for tracing back an optimum path, by associating with said information element ($102_A$, $102_B$) designating the last two nodes of said optimum path, a decoding sequence corresponding to said last two nodes as well as to the set of p-1 intermediate nodes (26) not preserved during the sub-sampling (51), p being an integer strictly greater than 1, chosen so that there is a single path (41; $23_A$, $23_B$) between a node (25) and its p order antecedent (24) in said initial trellis.

5. Device according to Claim 4, characterized in that said sub-sampling means (51) comprise a bank of $2^v$ registers, $v$ being the length of constraint of said convolutional code, each comprising p sets of $v$ flip-flops ($62_A$ to $62_D$, $63_A$ to $63_D$), said sets of $v$ flip-flops being interconnected (64) in accordance with the model defined by said initial trellis, so that the outputs of said registers respectively deliver the p order antecedent ($A^2_{A,n}$ to $A^2_{D,n}$) of each of the $2^v$ nodes corresponding to a preserved sample.

6. Device according to one of Claims 4 and 5, characterized in that said memorizing means comprise a circular random-access memory (91) organized into words of $2^v.v$ bits, where $v$ is the length of constraint of said convolutional code, a word containing the set of information elements associated with each of the nodes corresponding to a sample.

7. Device according to Claim 6, characterized in that said means for tracing back an optimum path comprise means (99) for addressing said memory (91), delivering a set of at least two words ($93_A$ to $93_C$), and means ($94_A$ to $94_C$) for the selection, in each of said words, of the information elements (96, 97, 98) corresponding to the node belonging to said optimum path.

8. Device according to any one of Claims 4 to 7, characterized in that said over-sampling means (53) include a transcoding table (101) associating, with an information element ($102_A$, $102_B$) designating the two nodes of said optimum path, the decoding sequence (103) corresponding to said two nodes and to the set of the p-1 intermediate nodes not preserved during the sub-sampling.

9. Device according to Claim 8, characterized in that said over-sampling means (53) comprise serializing means (104), delivering (105) said decoding sequence (103) at a rate equal to that of the arrival of said samples.

**10.** Device according to any one of Claims 4 to 9, characterized in that it is implanted in an integrated circuit.

Fig. 1

Fig. 2

Fig. 4

Fig. 3

Fig. 5

Fig. 8

$$H/p$$

$$H$$

Fig. 10

DA

61A     62A     63A

$A_{A,n}^2$

DB

61B     62B     63B

$A_{B,n}^2$

DC

61C

63C

$A_{C,n}^2$

62C

DD

61D

63D

62D     64

$A_{D,n}^2$

Fig. 6

D     H

D1

S

D2

71     72

Fig. 7

91    95    96    97

92

$A_{n-1}^P$    $A_{s,n-1}^P$

93A    94A

$A_{n-2}^P$    $A_{s,n-1}^{2p}$

$A_n^P$    93B    94B

$A_{n-3}^P$    $A_{s,n-1}^{3p}$

93C    94C    98

99

Fig.9